## Europäisches Patentamt
## European Patent Office
## Office européen des brevets

(11) Numéro de publication: **0 008 840**
**B1**

(12) **FASCICULE DE BREVET EUROPEEN**

(45) Date de publication du fascicule de brevet: **10.06.81**

(51) Int. Cl.³: **H 01 L 31/16**

(21) Numéro de dépôt: **79200496.2**

(22) Date de dépôt: **07.09.79**

(54) Dispositif optoélectronique à émetteur et récepteur couplés et procédé de réalisation d'un tel dispositif.

(30) Priorité: **12.09.78 FR 7826173**

(43) Date de publication de la demande:
**19.03.80 Bulletin 80/6**

(45) Mention de la délivrance du brevet:
**10.06.81 Bulletin 81/23**

(84) Etats Contractants Désignés:
**DE FR GB IT**

(56) Documents cités:
**DE - A - 2 431 375**

(73) Titulaire: **R.T.C. LA RADIOTECHNIQUE-COMPELEC Société anonyme dite:**
**51 rue Carnot**
**F-92156 Suresnes (FR)**

(73) Titulaire: **N.V. Philips' Gloeilampenfabrieken**
**Pieter Zeemanstraat 6**
**NL-5621 CT Eindhoven (NL)**

(72) Inventeur: **Groff, Alain**
**Société Civile S.P.I.D. 209, rue de l'Université**
**F-75007 Paris (FR)**
Inventeur: **Talpied, André**
**Société Civile S.P.I.D. 209, rue de l'Université**
**F-75007 Paris (FR)**

(74) Mandataire: **Labaloue, André et al,**
**209, rue de l'Université**
**F-75007 Paris (FR)**

Courier Press, Leamington Spa, England.

### Dispositif optoélectronique à émetteur et récepteur couplés et procédé de réalisation d'un tel dispositif

La présente invention concerne un dispositif optoélectronique comportant, un cristal émetteur de lumière qui repose sur un premier élément de connexion, un cristal récepteur de la lumière rayonnée par ledit cristal émetteur et qui repose sur un deuxième élément de connexion et une optique qui assure la transmission lumineuse du cristal émetteur vers le cristal récepteur, lesdits cristaux étant sensiblement coplanaires et disposés en regard de ladite optique, ces même cristaux étant reliés électriquement à d'autres éléments de connexion dudit dispositif.

On connaît différents types de dispositifs optoélectroniques comportant un émetteur et un récepteur de lumière couplés optiquement dans le but de transférer un signal électrique d'un premier circuit à un deuxième circuit totalement isolé du premier, par le jeu d'un faisceau lumineux. Ces dispositifs, plus particulièrement désignés sous l'appellation de "photocoupleurs", utilisent, le plus souvent, une diode électroluminescente comme émetteur et une photodiode, ou un phototransistor, ou encore une photorésistance, comme récepteur, tous ces composants étant des composants semiconducteurs.

Parmi les différents types de photocoupleurs, ceux répondant à la structure définie ci-dessus, dans laquelle le cristal émetteur et le cristal récepteur sont sensiblement coplanaires et regardent l'optique de transmission, sont particulièrement avantageux. Ceci, notamment, en raison de leurs meilleures performances en haute fréquence, comparées à celles de photocoupleurs de type différent (du fait de la faible capacité entre émetteur et récepteur), de la simplicité de leur montage et de la possibilité d'exécuter ce montage selon des techniques classiques couramment utilisées pour les fabrications de transistors et de circuits intégrés.

Dans une forme industrielle de réalisation d'un photocoupleur de type "coplanaire", illustrée dans la demande allemande n° 2 431 375 (publication avant mise à l'inspection publique, dite "AUSLEGE-SCHRIFT"), on utilise comme support de départ une bande métallique ajourée couramment appelée "peigne" ou "grille". Les ajours ont engendré dans ladite bande des languettes de connexion qui restent mécaniquement et électriquement solidaires entre elles durant presque tout le montage, maintenues telles par des bandelettes formant entretoises; l'opération de séparation, au cours de laquelle lesdites languettes de connexion sont isolées électriquement, n'intervient, en effet, qu'en fin de cycle de fabrication.

Les cristaux sont fixés, à distance convenable l'un de l'autre, sur deux languettes de connexion coplanaires et ils sont, d'autre part, reliés par des fils à des languettes de connexion latérales. En regard des cristaux est disposé un réflecteur dont la face réfléchissante a la forme d'un demi-ellipsoïde de révolution. Le volume intérieur du réflecteur est rempli, jusqu'au-delà du plan des cristaux, d'une résine transparente. Une enveloppe d'une résine synthétique opaque entoure le coeur du dispositif, soit les cristaux et le réflecteur, ainsi que les extrémités des languettes de connexion voisines desdits cristaux.

En liaison avec la fabrication des photocoupleurs et, en particulier, avec celle d'un photocoupleur coplanaire, il y a lieu de noter que la qualité électrique d'un tel dispositif est estimée, notamment, sur la valeur du rapport du transfert en courant, c'est-à-dire sur la valeur du rapport du courant de sortie côté récepteur au courant d'entrée côté émetteur. Physiquement, le transfert d'énergie entre les deux étages du photocoupleur implique plusieurs, étapes au cours desquelles une partie de l'énergie est perdue. Les pertes se différencient en pertes de conversion (conversion du courant en énergie lumineuse côté émetteur et vice-versa côté récepteur), en pertes par absorption dans les différents milieux traversés par la lumière et en pertes de transmission de l'énergie lumineuse (pertes dues au fait que les rayons lumineux issus de l'élément actif de l'émetteur ne convergent pas tous sur l'élément actif du récepteur).

De ces différentes pertes, les pertes de transmission sont incomparablement les plus élevées. Dans un photocoupleur coplanaire, ces pertes de transmission sont étroitement liées, en particulier, à la position de l'optique par rapport aux cristaux. Il suffit, en effet, d'un léger décalage de cette optique, pour que le rapport de transfert en courant chute de façon très sensible.

Dans l'exemple de réalisation d'un photocoupleur coplanaire selon la demande allemande citée plus haut, il n'est pas fait état de dispositions spéciales permettant une mise en place rigoureuse du réflecteur par rapport aux cristaux. Et quand bien même cette mise en place serait effectuée tout à fait correctement, rien ne s'oppose à un glissement du réflecteur sur les languettes de connexion sur lesquelles il est simplement posé, glissement qui risque de se produire durant les opérations ultérieures de finition, notamment durant les recuits de thermodurcissement des résines mises en jeu. On comprend, dès lors, que les rapports de transfert en courant de photocoupleurs ainsi réalisés soient très variables entre dispositifs semblables, en principe identiques.

La présente invention a pour but la réalisation de photocoupleurs de type coplanaire dans lesquels l'optique de transmission occupe, dès sa pose et sans erreur possible, une place parfaitement appropriée et stable. Elle vise, ce faisant, à réduire les disparités excessives des valeurs du rapport de transfert en courant entre photocoupleurs fondamentalement semblables.

L'invention a pour but, également, d'aider à la réalisation sur un mode industriel de tels photocoupleurs, en facilitant la mise en place mécanique automatique des optiques de transmission lumineuse.

Selon l'invention, un dispositif optoélectronique comportant, un cristal émetteur de lumière qui repose sur un premier élément de connexion, un cristal récepteur de la lumière rayonnée par ledit cristal émetteur et qui repose sur un deuxième élément de connexion, et une optique qui assure la transmission lumineuse du cristal émetteur vers le cristal récepteur, lesdits cristaux étant sensiblement coplanaires et disposés en regard de ladite optique, ces mêmes cristaux étant reliés électriquement à d'autres éléments de connexion dudit dispositif, est notamment remarquable en ce que ladite optique est munie d'un pied de centrage dont une partie est intercalée entre lesdits premier et deuxième éléments de connexion. La présence d'un pied de centrage lié à l'optique procure plusieurs avantages. En premier lieu, grâce au pied de centrage, on acquiert la certitude d'une parfaite mise en place de l'optique par rapport aux cristaux émetteur et récepteur; il est prévu, en effet, que le pied de centrage soit intercalé entre les deux éléments de connexion qui supportent lesdits cristaux. Il suffit donc, pour obtenir le résultat escompté, que les largeurs respectives dudit pied de centrage et de l'espace séparatif entre lesdits éléments de connexion soient convenablement ajustées l'une à l'autre, avec un jeu approprié tenant compte des tolérances de réalisation des pièces et des tolérances de montage.

De plus, grâce au pied de centrage, on est assuré que l'optique et les cristaux occupent bien des positions relatives sensiblement identiques d'un photocoupleur à un autre. Il faut remarquer également que la présence d'un pied de centrage concourt à stabiliser l'optique en une position prédéfinie avec précision, que ne peuvent modifier les opérations de fabrication postérieures à la mise en place de ladite optique, notamment les recuits de polymérisation des résines. Le pied de centrage permet aussi d'accélérer la fabrication des photocoupleurs coplanaires. Dans le cas d'une mise en place manuelle de l'optique, il constitue un élément repère, qui évite les tâtonnements lors de la pose de cette optique et qui dispense d'une vérification attentive après cette pose. Il autorise l'emploi de moyens automatiques pour la distribution, l'orientation et la mise en place de l'optique. Les avantages cités précédemment, de précision de mise en place, de stabilité, de possibilité de l'emploi de moyens automatiques, que procure la présence d'un pied de centrage, se traduisent par un niveau de qualité moyenne plus élevé des photocoupleurs réalisés comparés à ceux de fabrication antérieures et par un meilleur groupement de leurs caractéristiques de transfert en courant d'où, sur le plan économique, un meilleur rendement de fabrication.

Dans une forme avantageuse de réalisation d'un photocoupleur coplanaire selon l'invention, on distingue trois parties dans l'optique équipant ce photocoupleur: la partie optique proprement dite, par exemple demi-ellipsoïdique, qui surmonte une partie plane d'épaisseur régulière que l'on peut considérer comme étant une embase, à laquelle sur la face opposée à la partie demi-ellipsoïdique précitée, adhère la troisième partie, soit le pied de centrage. L'ensemble de l'optique, qui forme un bloc monolithique solide, est réalisé en une résine synthétique transparente.

L'embase déborde latéralement des deux autres parties du pied. Une pareille disposition est intéressante en ce qu'elle permet que les optiques soient groupées, dès leur moulage, en lignes et colonnes, sur des plaquettes, où elles se présentent réunies par leurs embases. On peut alors traiter ces plaquettes de la même manière que, pour la fabrication des transistors et des circuits intégrés, l'on traite les plaquettes de silicium porteuses d'une pluralité de cristaux semblables, et obtenir ainsi la séparation des optiques, et leur mise en place, avec des machines semblables à celles utilisées pour lesdits transistors et circuits intégrés.

D'autre part, le pied de centrage est conformé de façon telle qu'il puisse être intercalé, non seulement entre les éléments de connexion sur lesquels sont fixés les cristaux émetteur et récepteur, mais aussi dans les espaces séparatifs situés entre ces éléments de connexion précités et lesdits autres éléments de connexion faisant partie du photocoupleur. Ceci permet d'annuler pratiquement tout mouvement de l'optique par rapport aux cristaux dans une direction quelconque parallèle au plan de ces cristaux.

De plus, il est prévu que le pied de centrage repose, par des parties de sa structure, sur les éléments de connexion du photocoupleur autres que lesdits premier et deuxième éléments. Au-dessus de ces premier et deuxième éléments de connexion, le pied de centrage comporte, au contraire, des creusures, qui permettent le libre déploiement des fils de liaison unissant électriquement les cristaux auxdits autres éléments de connexion.

Toutes ces particularités ressortiront plus clairement de la description qui va suivre et des figures y annexées parmi lesquelles:

La figure 1A représente, vu de dessus, un photocoupleur selon l'invention à un stade de sa fabrication où l'optique qui caractérise ledit photocoupleur a été mise en place. La figure 1B est une vue en coupe selon la ligne I.I de la figure 1A.

Les figures 2A et 2D représentent ladite optique des figures 1 vue sous différents angles d'observation. Les figures 2A et 2B sont des vues en élévation sous deux directions orthogonales; la figure 2C est une vue de dessus; la figure 2D est une vue de dessous en perspective.

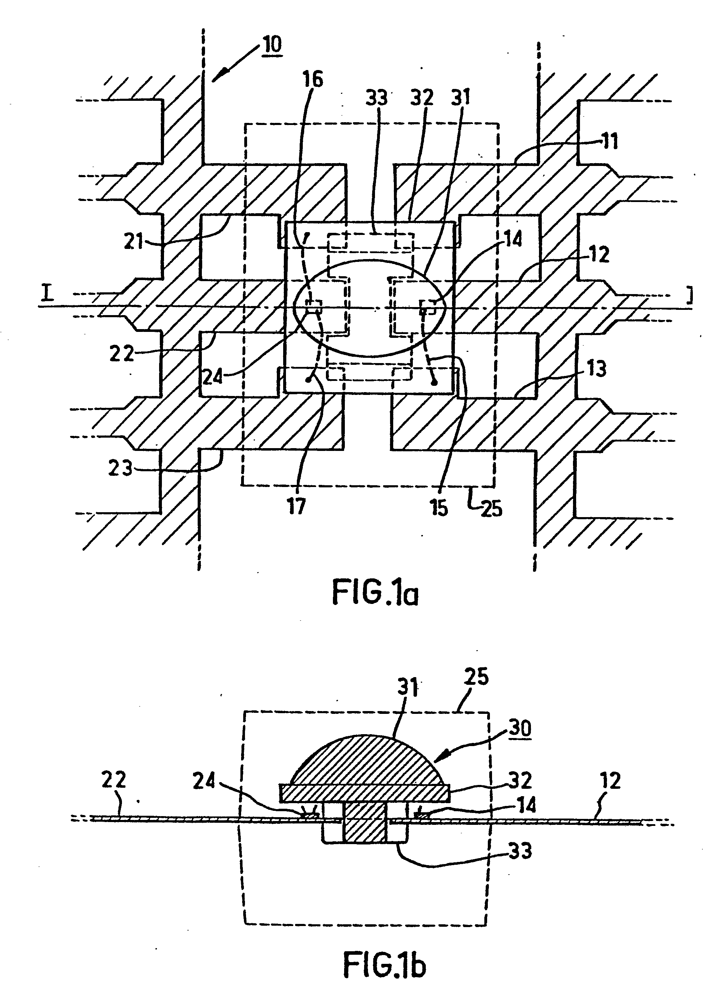

Le photocoupleur coplanaire représenté sur les figures 1A et 1B à un stade de sa fabrication proche du but final est réalisé sur une grille ou peigne métallique — par exemple en ferronickel et obtenue, de façon connue, par découpe, estampage ou gravure d'une bande métallique pleine — qui comporte des motifs identiques de six éléments de connexion régulièrement répartis sur la longueur de la grille. Chaque motif, tel que le motif 10 qui couvre la figure 1A, est réservé pour la fabrication d'un photocoupleur.

Les six éléments de connexion du motif 10 sont rangés en deux groupes coplanaires de trois éléments parallèles régulièrement espacés. Le premier groupe est formé des languettes 11, 12, 13; le second groupe comprend les languettes 21, 22, 23. On observe que les languettes 11 et 21, 12 et 22, 13 et 23, sont alignées et se font face par leur bord de largeur; d'autre part, les languettes 11, 21, 13 et 23 sont prévues légèrement plus larges à leur extrémité libre de manière à diminuer leur écartement par rapport aux languettes 12 et 22 et à faciliter ainsi les liaisons électriques par fils avec les cristaux du photocoupleur.

Le photocoupleur réalisé sur cette grille comporte un cristal semiconducteur émetteur de lumière 14 — une diode électroluminescente — qui a été fixé par les moyens habituels, soudure ou collage, sur la languette 12, et un cristal semi-conducteur récepteur de lumière 24 — par exemple, un phototransistor — qui a été fixé, également soit par soudure, soit par collage, sur la languette 22. La diode 14 est connectée par le fil de liaison 15 à la languette 13. Le phototransistor 24, par ailleurs, est connecté, d'une part à la languette 21 par le fil de liaison 16, d'autre part à la languette 23 par le fil de liaison 17.

La transmission lumineuse entre les cristaux 14 et 24 doit être assurée par une optique 30 dont la partie active 31 est située au-dessus desdits cristaux.

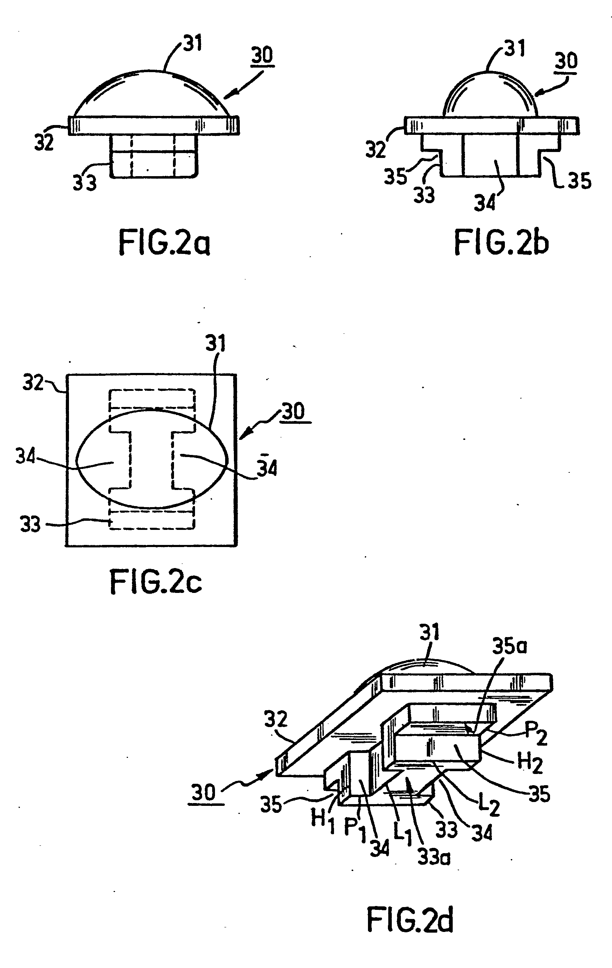

Selon l'invention, un dispositif électronique comportant, un cristal émetteur de lumière 14 qui repose sur un premier élément de connexion 12, un cristal récepteur 24 de la lumière rayonnée par ledit cristal émetteur 14 qui repose sur un deuxième élément de connexion 22, et une optique 30 qui assure la transmission lumineuse du cristal émetteur 14 vers le cristal récepteur 24, lesdits cristaux 14 et 24 étant sensiblement coplanaires et disposés en regard de ladite optique 30, ces mêmes cristaux étant reliés électriquement à d'autres éléments de connexion 13, 21 et 23 dudit dispositif, est notamment remarquable en ce que ladite optique 30 est munie d'un pied de centrage 33 (voir fig. 1 et 2) dont une partie est intercalée entre lesdits premier et deuxième éléments de connexion 12 et 22.

Dans une forme avantageuse de réalisation de l'optique 30 illustrée particulièrement sur les figures 2, on distingue dans cette optique trois parties: une première partie ou lentille 31 sensiblement en forme de demi-ellipsoïde de ré-volution, qui surmonte une deuxième partie 32 plane et d'épaisseur régulière que l'on conviendra de désigner "embase" et que prolonge une troisième partie 33 comportant les moyens de son centrage dans le photocoupleur. L'ensemble est solide, monolithique et réalisé, par exemple, en une résine transparente d'indice de réfraction élevé.

Le pied de centrage de l'optique 30 est conformé de telle manière qu'il s'inscrit dans un parallélépipède dont les faces latérales sont parallèles aux axes de la lentille 30. On y observe deux couples de creusures créées sur lesdites faces latérales.

Le premier couple est formé des creusures symétriques 34 dont, pour chacune, la longueur $L_1$ (voir figure 2D) parallèle au petit axe de la lentille 31, est très légèrement supérieure à la largeur des languettes 12 et 22, la profondeur $P_1$ est choisie pour que l'épaisseur du pied 33 entre lesdites creusures 34 soit légèrement inférieure à la distance séparant les bords en regard desdites languettes 12 et 22, et la hauteur $H_1$ couvre la hauteur totale du pied 33. Le deuxième couple de creusures comprend les creusures symétriques 35 de longueur $L_2$ parallèle au grand axe de la lentille 31, de profondeur $P_2$ telle que l'épaisseur du pied 33 entre elles soit légèrement inférieure à la distance séparant les languettes soit 11 et 13, soit 21 et 23 au voisinage des extrémités libres de ces languettes, et de hauteur $H_2$, comptée à partir de la face 33a du pied 33, inférieure à celle dudit pied, ce qui engendre un dénivelle-ment entre les faces 35a desdites creusures et ladite face 33a. Munie d'un pied 33 comformé tel que décrit ci-dessus, l'optique 30 repose, sans jeu appréciable, en regard des cristaux 14 et 24 (voir figures 1A et 1B). Elle s'appuie, par les faces 35a des creusures 35, sur les languettes 11 et 21 d'une part, 13 et 23 d'autre part. Toute la partie de hauteur $H_2$ dudit pied 33 est intercalée entre les languettes 12 et 22 (partie du pied située entre les creusures 34) et aussi dans les espaces séparatifs entre les connexions 11 et 12, 21 et 22, 12 et 13, 22 et 23.

Ainsi, l'optique 30 se trouve-t-elle fixée à une place bien déterminée et empêchée de glisser dans quelque direction que ce soit parallèlement aux plans des languettes et des cristaux.

Les cristaux 14 et 24 sont situés à l'entrée des creusures 34 qui s'étendent, en hauteur, au-dessus desdits cristaux. Aussi, les fils de liaison 15, 16 et 17 ne risquent-ils pas d'être touchés lors de la mise en place de l'optique 30. Il est compréhensible que la présence d'un pied de centrage lié à l'optique d'un photocoupleur coplanaire facilite la réalisation d'un tel dispositif, ledit pied de centrage aidant à l'orientation de l'optique tant pour sa distribution que pour sa mise en place. L'embase 32 prévue en plus du pied de centrage 33 dans la forme d'optique décrite précédemment, apporte un avantage complémentaire dans la fabrication d'un photocoupleur coplanaire en ce sens qu'elle en facilite la réalisation par des moyens automatiques. L'embase 32 permet, en effet, que des optiques puissent être réunies par son intermédiaire, par plusieurs centaines, en des plaquettes où elles sont régulièrement réparties en lignes et colonnes suivant une orientation choisie. Une plaquette et ses optiques constitue en ensemble monolithique qui est obtenu directement par moulage. Il faut, au stade de l'emploi, séparer les optiques. On pratique donc entre elles des rainures longitudinales et transversales qui délimitent les contours de forme carrée ou rectangulaire d'embases telle que l'embase 32, et permettent la séparation complète des optiques à l'instant de leur emploi. Les operations de rainurage, de séparation complète, de prélèvement des optiques pour la mise en place et de mise en place, peuvent être conduites de la même manière que lorsqu'il s'agit de dispositifs semiconducteurs réalisés sur une même plaquette de silicium, et avec les mêmes matériels, d'où la possibilité d'une mécanisation aux moindres frais.

Il va de soi que l'exemple de mise en oeuvre de l'invention que a été illustré sur les figures 1 et 2 n'a pas un caractère limitatif. Notamment, la structure du motif 10, les formes, dimentions et positions respectives de éléments de connexion, la forme de la lentille 31, qui peut être revêtue d'un dépôt réfléchissant, celle du pied de centrage 33, peuvent être modifiées et permettre, malgré des changements de détails, la mise en oeuvre de l'invention.

La réalisation d'un photocoupleur coplanaire selon l'invention ne présente aucun caractère particulier, hormis l'intervention rendue possible de la machine. Après la mise en place des constituants du photocoupleur, on étale une goutte de résine transparente entre l'embase 32 et les cristaux 14 et 24 pour assurer un joint optique entre lesdits cristaux et la lentille 31, on laisse se solidifier cette goutte de résine, puis on enveloppe le dispositif dans un bloc solide d'une résine opaque. Le contour dudit bloc a été figuré en trait tireté et porte le re 25 sur les figures 1A et 1B. Les parties c nguettes 11, 12 et 13, 21, 22 et 23 ext res au bloc, séparées les unes de autres, so ensuite cambrées de façon convenable.

## Revendications

1. Dispositif optoélectronique comportant, un cristal émetteur de lumière (14) qui repose sur un premier élément de connexion (12), un cristal récepteur (24) de la lumière rayonnée par ledit cristal émetteur et qui repose sur un deuxième élément de connexion (22), et une optique (30) qui assure la transmission lumineuse du cristal émetteur vers le cristal récepteur, lesdits cristaux étant sensiblement coplanaires et disposés en regard de ladite optique, ces mêmes cristaux étant reliés électriquement à d'autres éléments de connexion (13, 21, 23) dudit dispositif, caractérisé en ce que ladite optique (30) est munie d'un pied de centrage (33) dont une partie est intercalée entre lesdits premier (12) et deuxième (22) éléments de connexion.

2. Dispositif optoélectronique selon la revendication 1, caractérisé en ce que ledit pied de centrage (33) est, de plus, intercalé dans les espaces séparatifs situés entre lesdits premier et deuxième éléments de connexion d'une part, et lesdits autres éléments de connexion d'autre part.

3. Dispositif optoélectronique selon l'une des revendications 1 et 2, caractérisé en ce que ledit pied de centrage (33) repose, par des parties (35a) de sa structure, sur au moins certains (11, 21, 13, 23) des éléments de connexion, à l'exclusion desdits premier et deuxième de ces éléments.

4. Dispositif optoélectronique selon l'une des revendications précédentes, caractérisé en ce que la partie (31) de l'optique (30) qui assure la transmission lumineuse et ledit pied de centrage (33) sont disposés de part et d'autre d'une embase plane (32), l'ensemble constituant un composant monolithique.

5. Procédé de réalisation d'un dispositif optoélectronique selon la revendication 4, caractérisé en ce que lesdites optiques (30), obtenues par moulage d'un matériau transparent, se présentent, au sortir du moulage, réunies en des plaquettes par leurs embases (32), régulièrement disposées en lignes et colonnes dans ces plaquettes, et en ce qu'elles sont ensuite séparées selon les contours desdites embases pour être mises en place dans lesdits dispositifs.

## Patentansprüche

1. Optoelektronische Anordnung, die einen lichtemittierenden Kristall (14), der auf einem ersten Verbindungselement (12) ruht, einen Kristall (24), der das von dem genannten emittierenden Kristall ausgestrahlte Licht empfängt und auf einem zweiten Verbindungselement (22) ruht, sowie ein optisches System (30) enthält, das für die Lichtübertragung von dem emittierenden Kristall auf den empfangenden Kristall sorgt, wobei die genannten Kristalle wenigstens annähernd koplanar sind und dem genannten optischen System gegenüber liegen, und wobei die Kristalle elektrisch mit anderen Verbindungselementen (13, 21, 23) der genannten Anordnung verbunden sind, dadurch gekennzeichnet, dass das genannte optische System (30) mit einem Zentrierfuss (33) versehen ist, von dem ein Teil zwischen dem genannten ersten (12) und dem genannten zweiten (22) Verbindungselement angeordnet ist.

2. Optoelektronische Anordnung nach Anspruch 1, dadurch gekennzeichnet, dass der genannte Zentrierfuss (33) ausserdem in die Trennräume zwischen einerseits dem genannten ersten und dem genannten zweiten Verbindungselement und andererseits den genannten anderen Verbindungselementen eingeführt ist.

3. Optoelektronische Anordnung nach einem der Ansprüche 1 und 2, dadurch gekennzeichnet, dass der genannte Zentrierfuss (33) mit Teilen (35a) seiner Struktur auf wenigstens einigen (11, 21, 13, 23) der Verbindungselemente ruht, mit Ausnahme des genannten ersten und des genannten zweiten dieser Elemente.

4. Optoelektronische Anordnung nach einem der vorhergehenden Ansprüche, dadurch gekennzeichnet, dass das Teil (31) des optischen Systems (30), das für die Lichtübertragung sorgt, und der genannte Zentrierfuss (33) zu beiden Seiten eines flachen Trägers (32) liegen, wobei dieses Gebilde eine bauliche Einheit bildet.

5. Verfahren zur Herstellung einer optoelektronischen Anordnung nach Anspruch 4, dadurch gekennzeichnet, dass die genannten optischen Systeme (30), die durch Giessen eines transparenten Materials erhalten werden, nach dem Giessvorgang mit ihren Trägern (32) zusammenhängend sind und die Form von Platten einnehmen, wobei die Träger auf regelmässige Weise in Zeilen und Spalten in diesen Platten angeordnet sind, und dass sie dann längs der Umrisse der genannten Träger voneinander getrennt und in den genannten Anordnungen an ihre Stelle gebracht werden.

## Claims

1. An opto-electronic device comprising a semi-conductor transmitter crystal (14) which emits light and which is mounted on a first connection element (12), a receiver crystal (24) which receives the light emitted by the said transmitter crystal and which is mounted on a second connection element (22), and an optical element (30) which ensures light transmission between the transmitter crystal and the receiver crystal, the said crystals being substantially coplanar and positioned opposite the optical element, the said crystals being connected electrically to other connection elements (13, 21, 23) of the device, characterized in that the said optical element (30) has a centring base (33) a part of which is positioned between the said first (12) and second (22) connection elements.

2. An opto-electronic device as claimed in Claim 1, characterized in that the centring base (33) is positioned in the intermediate space between the first and second connection elements on the one hand and the said other connection elements on the other hand.

3. An opto-electronic device as claimed in Claim 1 or 2, characterized in that parts (35a) of said centring base (33) bear on connection elements (11, 21, 13, 23) other than said first and second connection elements.

4. An opto-electronic device as claimed in any of the preceding Claims, characterized in that the part (31) of the optical element (30) which ensures light transmission and the said centring base (33) are provided on either side of a flat supporting plate (32), the assembly constituting a monolithic component.

5. A method of manufacturing an opto-electronic device as claimed in Claim 4, characterized in that the said optical elements (30) obtained by moulding a transparent material are united after moulding in a planar array by their supporting plates (32) which are situated in a regular array of lines and columns in said planar array and that these optical elements are then severed at the edges of the supporting plates in order to be provided separately for the said devices.

FIG.1a

FIG.1b

FIG.2a

FIG.2b

FIG.2c

FIG.2d